# EUROPÄISCHE PATENTSCHRIFT

(11) **EP 3 017 666 B1**
(45) Veröffentlichungstag und Bekanntmachung des Hinweises auf die Patenterteilung: **02.08.2017**
(21) Anmeldenummer: 14738355.8
(22) Anmeldetag: 23.06.2014
(51) Int. Cl.: H05K 1/18, H01L 23/538, H01L 23/00, H05K 3/00, H05K 3/02, H01L 21/56

(54) **VERFAHREN ZUM ANKONTAKTIEREN UND UMVERDRAHTEN EINES IN EINER LEITERPLATTE EINGEBETTETEN ELEKTRONISCHEN BAUTEILS**
PROCESS FOR CONTACTING AND CIRCUITIZING AN ELECTRONIC COMPONENT EMBEDDED IN A PRINTED CIRCUIT BOARD
PROCÉDÉ POUR CONTACTER ET CONNECTER À UN CIRCUIT UN COMPOSANT ENCAPSULÉ DANS UN CIRCUIT IMPRIMÉ

(30) Priorität: 04.07.2013 AT 504392013
(43) Veröffentlichungstag der Anmeldung: 11.05.2016
(73) Patentinhaber: AT & S Austria Technologie & Systemtechnik Aktiengesellschaft, 8700 Leoben (AT)
(72) Erfinder: SCHRITTWIESER, Wolfgang, A-8605 Kapfenberg (AT); MORIANZ, Mike, A-8045 Graz (AT); KASPER, Alexander, A-8055 Graz (AT); PREINER, Erich, A-8770 St. Michael (AT); KRIVEC, Thomas, A-8740 Zeltweg (AT)
(74) Vertreter: Patentanwaltskanzlei Matschnig & Forsthuber OG
(86) Internationale Anmeldenummer: PCT/AT2014/050137
(87) Internationale Veröffentlichungsnummer: WO 2015/000007

(56) Entgegenhaltungen:
- WO-A1-2010/048654
- WO-A2-2010/048653
- US-A1- 2010 212 946

## Beschreibung

Die Erfindung betrifft ein Verfahren zum Ankontaktieren und Umverdrahten eines in eine Leiterplatte eingebetteten elektronischen Bauteils sowie eine entsprechende Leiterplatte.

Bei Leiterplatten für die Montage und elektrische Verbindung von Halbleiterelementen besteht die Tendenz zu einem immer höheren Grad der Miniaturisierung, wobei die Halbleiterelemente zunehmend platzsparend in die Leiterplatte integriert und nicht auf deren Oberfläche festgelegt werden. Die Halbleiterelemente werden hierbei derart in das elektrisch isolierende Leiterplattenmaterial - in aller Regel ein Prepreg-Material wie zum Beispiel FR4-Material - eingebettet, dass das gesamte Volumen des Halbleiterelements im Querschnitt der Leiterplatte aufgenommen ist und lediglich die Kontakte bzw. Anschlüsse des Halbleiterelements an der Kontaktseite der Leiterplatte im Wesentlichen plan an der Oberfläche der Leiterplatte freiliegen und somit für die Verdrahtung des Halbleiterelements durch auf der Leiterplatte ausgebildete Leiterzüge aus einem elektrisch leitenden Material, wie zum Beispiel Kupfer oder Aluminium, zugänglich sind. Derartige Leiterplatten mit integrierten Halbleiterelementen weisen zumeist eine Vielzahl von einander abwechselnden elektrisch isolierenden und zur Ausbildung von Leiterzügen strukturierten elektrisch leitenden Schichten auf, die in einem sequentiellen Verfahren übereinander laminiert werden, sodass die eingebetteten Halbleiterelemente vor dem Ankontaktieren in der Regel durch eine Vielzahl solcher Schichten überdeckt sind.

Gemäß den bekannten Vorgehensweisen aus dem Stand der Technik werden die derart verdeckten Kontakte bzw. Anschlüsse der Halbleiterelemente mit einem Laserschneidverfahren freigelegt, bei dem ein Laserstrahl die über den Kontakten bzw. Anschlüssen der Halbleiterelemente gelegenen Schichten aus isolierendem Material von der Oberfläche der Leiterplatte bis zum Metall des Kontakts hinunterschneidet, woraufhin die dabei gebildeten Freistellungen mit Kupfer oder einem anderen elektrischen Leiter verfüllt werden, um die Ankontaktierung zu bewerkstelligen.

Das Laserschneidverfahren ist jedoch insofern nachteilig, als die durch den Laser eingebrachte Wärme bei immer kleineren Halbleiterelementen und folglich immer kleineren Leiterplatten zu Beschädigungen der empfindlichen Halbleiterelemente führen kann, Als nächstliegender Stand der Technik ist Dokument WO2010/048653-A2 bekannt. Es ist daher Aufgabe der vorliegenden Erfindung, ein Verfahren der eingangs genannten Art anzugeben, mit dem auch bei sehr kleinbauenden Halbleiterelementen und entsprechend dimensionierten Leiterplatten eine präzise Ankontaktierung und Verdrahtung der Halbleiterelemente auf der Leiterplatte erfolgen kann, wobei ein übermäßiger Hitzeeintrag in die Leiterplatte und damit einhergehend eine Schädigung der Halbleiterelemente vermieden werden soll. Diese Aufgabe wird mit einem Verfahren gelöst, welches erfindungsgemäß durch die folgenden Schritte gekennzeichnet ist:
Auftragen einer ersten Permanentresistschicht auf eine Kontaktseite der Leiterplatte,
Strukturieren der ersten Permanentresistschicht zum Herstellen von Freistellungen im Bereich von Kontakten des elektronischen Bauteils
Auftragen zumindest einer zweiten Permanentresistschicht auf die strukturierte erste Permanentresistschicht
Strukturieren der zweiten Permanentresistschicht zum Freilegen der Freistellungen im Bereich der Kontakte und zum Herstellen von Freistellungen entsprechend den gewünschen Leiterzügen.

### Chemisches Beschichten der Freistellungen mit Kupfer

### Galvanisches Auffüllen der Freistellungen mit Kupfer

Abtragen von Kupferüberschuss in den Bereichen zwischen den Freistellungen.

Es ist somit bei dem erfindungsgemäßen Verfahren vorgesehen, die Freistellungen für das Ankontaktieren und Verdrahten der Halbleiterelemente anstatt in herkömmlichen isolierenden Schichten aus Prepreg-Material wie zum Beispiel FR4 in Schichten aus Permanentresist auszubilden, sodass keine Notwendigkeit besteht, über den Kontakten bzw. Anschlüssen der Halbleiterelement liegende Schichten durch Laserschneiden zu entfernen, sondern lediglich der Permanentresist durch Belichten, Entwickeln und Entfernen bzw. Strippen der entwickelten Bereiche strukturiert werden muss. Der Fotolack bzw. Permanentresist verbleibt hierbei in den nicht strukturierten Bereichen auf der fertigen Leiterplatte und dient in jenen Lagen der Leiterplatte, in denen die Ankontaktierung und die Verdrahtung bzw. Entflechtung der Halbleiterelemente erfolgt, folglich als Dielektrikum anstelle des herkömmlichen Prepreg-Materials wie zum Beispiel FR4 oder auch Polyimid. Dadurch, dass das Laserschneidverfahren entfallen kann, wird eine Beschädigung der Leiterplatte und der darin eingebetteten Halbleiterelement vermieden.

Um den Platz auf der Leiterplatte besser für die Umverdrahtung von elektronischen Bauelementen wie Halbleiterelementen zu nutzen, ist die Erfindung bevorzugt dahingehend weitergebildet, dass der Schritt des Auftragens zumindest einer zweiten Permanentresistschicht zusätzlich das Auftragen einer Permanentresistschicht auf die der Kontaktseite der Leiterplatte gegenüberliegende Seite der Leiterplatte umfasst. Im darauffolgenden Schritt des Strukturieren der zweiten Permanentresistschicht wird auch diese Permanentresistschicht strukturierte, um auch auf der der Kontaktseite der Leiterplatte gegenüberliegenden Seite der Leiterplatte Leiterzüge auszubilden. Das Resultat dieser bevorzugten Verfahrensführung ist daher eine Leiterplatte mit strukturierten elektrisch leitenden Schichten zu beiden Seiten der Leiterplatte, wobei die elektrisch leitenden Schichten durch Verfüllen der Freistellungen in einem Permanentresist bzw. Fotolack hergestellt sind.

Herkömmlicher Weise werden Permanentresist-Materialien dergestalt belichtet, dass die kontinuierliche Fotolack-Schicht mit einer lichtundurchlässigen Maske bedruckt, danach belichtet und einer chemischen Behandlung unterzogen wird, bei der je nach Art Lacks die unbelichteten oder die belichteten Bereich bestehen bleiben und die verbleibenden Bereiche entfernt werden. Bei den sogenannten Positivlacken bleiben die verdeckten und somit unbelichteten Bereiche bestehen, während bei den sogenannten Negativlacken, die unverdeckten und somit belichteten Bereiche bestehen bleiben. Das Aufdrucken der Maske ist hierbei ein relativ aufwendiger Prozessschritt, weswegen es in Anwendung einer demgegenüber verbesserten und daher bevorzugten Ausführungsform der vorliegenden Erfindung vorgesehen ist, dass das Strukturieren der Permanentresistschichten das Belichten der Permanentresistschichten mit einem Laser umfasst. Hierbei wird ein Laserstrahl entsprechend dem gewünschten Belichtungsbild über die kontinuierliche Permanentresistschicht gelenkt, sodass das Aufbringen einer photolithographischen Maske entfallen kann.

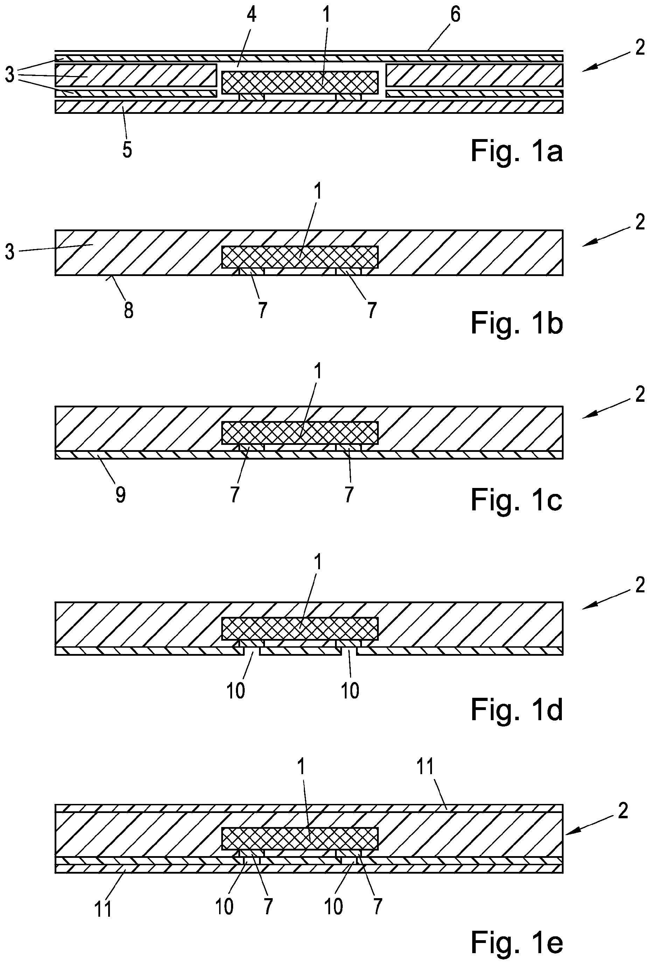

Die Erfindung wird nachfolgend anhand eines in der Zeichnung dargestellten Ausführungbeispiels näher erläutert. In dieser zeigen die Figuren 1a) bis 1i) schematische Schnittdarstellungen der einzelnen erfindungsgemäßen Verfahrensschritte. Um Wiederholungen zu vermeiden, sind in den Zeichnungen gleiche Teile der Leiterplatte mit gleichen Bezugszeichen versehen.

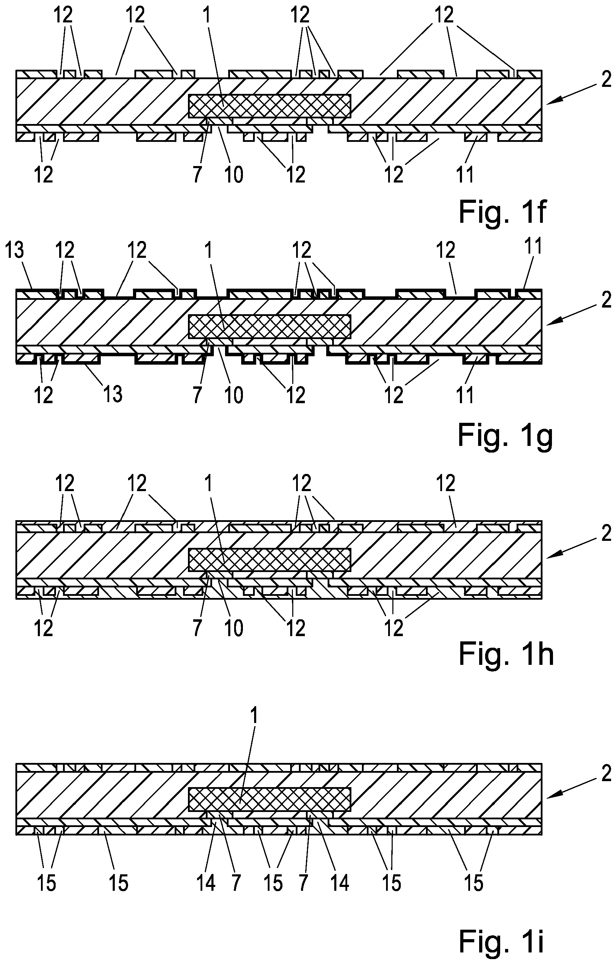

In Fig. 1a) ist ein Halbleiterelement mit 1 bezeichnet. Das Halbleiterelement 1 ist innerhalb des Querschnitts der Leiterplatte 2 aufgenommen. In Fig. 1a) ist die Leiterplatte vor einem Laminierungsschritt dargestellt und es ist zu erkennen, das die einzelnen Prepreg-Schichten 3 eine Ausnehmung 4 ausbilden, in das Halbleiterelement 1 aufgenommen ist. In dem Zustand in Fig. 1a) ist das Harz der einzelnen Prepreg-Schichten noch nicht verflossen und auch noch nicht ausgehärtet. Da das Halbleiterelement bei diesem speziellen Herstellungsverfahren nicht in bereits gehärtete Prepreg-Schichten eingeklebt, sondern mit diesen durch das Harz der Prepreg-Schichten vergossen wird, ist es notwendig, das Halbleiterelement 1 vor dem Laminieren, bei dem es zum Aushärten der Prepregs kommt, mithilfe eines Klebebandes 5 in der Ausnehmung 4 temporär festzulegen. Zum Laminieren wird zusätzlich eine Folie aufgebracht. Nach dem Laminieren dieses Verbundes und Entfernen des Klebebandes 5 sowie der Folie 6 erhält man das Produkt gemäß Figur 1 b), bei dem die Prepreg-Schichten 3 zu einer praktisch homogenen Prepreg-Schicht 3 verflossen und in der Folge ausgehärtet sind. Das Halbleiterelement 1 definiert mit seinen freiliegenden Kontakten 7 eine Kontaktseite 8 der Leiterplatte 2, auf der das Ankontaktieren und Verdrahten des Halbleiterelements 1 erfolgt.

Gemäß der Darstellung in Fig. 1 c) wird nun eine erste Permanentresistschicht 9 auf die Kontaktseite 8 der Leiterplatte 2 aufgebracht und durch Belichten, Entwickeln und Strippen strukturiert, wobei Freistellungen 10 gebildet werden, die die Kontakte 7 für das später erfolgende Ankontaktieren zugänglich machen (Fig. 1 d)). Das Belichten kann hierbei, wie oben beschrieben, mit einem Laser erfolgen. Beim Entwickeln der ersten Permanentresistschicht wird der verbleibende Fotolack chemisch derart verändert, dass nach einer erneuten Belichtung desselben Materials keine Entwicklung mehr erfolgt.

Anschließend wird eine zweite Permanentresistschicht 11 aufgetragen (Fig. 1 e)), die die im oben beschriebenen Schritt gebildeten Freistellungen 10 zwar zumindest teilweise wieder verschließt, jedoch vor allem die Möglichkeit schafft, durch geeignetes Strukturieren dieser frischen, zweiten Permanentresistschicht 11 Freistellungen 12 entsprechend den gewünschten Leiterzügen zu schaffen (Fig. 1 f)), wobei hier hervorgehoben wird, dass in diesem Fall der Schritt des Auftragens einer zweiten Permanentresistschicht 11 zusätzlich das Auftragen einer Permanentresistschicht 11 auf die der Kontaktseite 8 der Leiterplatte 2 gegenüberliegende Seite der Leiterplatte 2 umfasst.

Hierauf erfolgt der Schritt des chemischen Verkupferns der Freistellungen 10 und 12, wobei eine dünne Kupferschicht 13 auf dem Permanentresistmaterial und insbesondere in den Freistellungen 10 und 12 abgelagert wird (Fig. 1 g). Nun kann das galvanische Auffüllen der Freistellungen 10 und 12 mit Kupfer erfolgen, wodurch ein Produkt wie in Fig. 1 h) dargestellt erhalten wird. Schließlich muss das überschüssige Kupfer in den Bereichen zwischen den Freistellungen 10 und 12 abgetragen werden, um die fertige Leiterplatte 2 zu erhalten (Fig. 1 i). Die Ankontaktierungen 14 der Kontakte 7 der Halbleiterelement 1 und die Leiterzüge 15 wurden mit dem erfinderischen Verfahren ausgebildet, ohne das Halbleiterelement 1 übermäßig zu erhitzen.

Es ist selbstverständlich, dass die so erhaltene Leiterplatte weiteren Bearbeitungsschritten unterworfen werden kann, ohne vom Schutzumfang der hierin beanspruchten Erfindung abzuweichen.

## Patentansprüche

1. Verfahren zum Ankontaktieren und Umverdrahten eines in eine Leiterplatte (2) eingebetteten elektronischen Bauteils (1) **gekennzeichnet durch** die folgenden Schritte:
Auftragen einer ersten Permanentresistschicht (9) auf eine Kontaktseite (8) der Leiterplatte (2),
Strukturieren der ersten Permanentresistschicht (9) zum Herstellen von Freistellungen (10) im Bereich von Kontakten (7) des elektronischen Bauteils (1),
Auftragen einer zweiten Permanentresistschicht (11) auf die strukturierte erste Permanentresistschicht (9),
Strukturieren der zweiten Permanentresistschicht (11) zum Freilegen der Freistellungen (10) im Bereich der Kontakte (7) und zum Herstellen von Freistellungen (12) entsprechend den gewünschten Leiterzügen (15),
Chemisches Beschichten der Freistellungen (10,12) mit Kupfer,
Galvanisches Auffüllen der Freistellungen (10,12) mit Kupfer,
Abtragen von Kupferüberschuss in den Bereichen zwischen den Freistellungen (10).

2. Verfahren nach Anspruch 1, **dadurch gekennzeichnet, dass** der Schritt des Auftragens einer zweiten Permanentresistschicht (11) zusätzlich das Auftragen einer Permanentresistschicht (11) auf die der Kontaktseite (8) der Leiterplatte (2) gegenüberliegende Seite der Leiterplatte (2) umfasst.

3. Verfahren nach Anspruch 1 oder 2, **dadurch gekennzeichnet, dass** das Strukturieren der Permanentresistschichten (9, 11) das Belichten der Permanentresistschichten (9, 11) mit einem Laser umfasst.

4. Leiterplatte (2) erhältlich nach einem der Ansprüche 1 bis 3.

## Claims

1. A method for contacting and rewiring an electronic component (1) embedded in a printed circuit board (2), **characterized by** the following steps
Applying a first permanent resist layer (9) to a contact side (8) of the printed circuit board (2); Structuring the first permanent resist layer (9) for producing exposed areas (10) in the region of contacts (7) of the electronic component (1);
Applying a second permanent resist layer (11) to the structured first permanent resist layer (9); Structuring the second permanent resist layer (11) for exposing the exposed areas (10) in the region of the contacts (7) and for producing exposed areas (12) corresponding to the desired conductor tracks (15);
Chemically coating the exposed areas (10, 12) with copper;
Filling the exposed areas (10, 12) by electroplating with copper;
Removing the excess copper in the regions between the exposed areas (10).

2. The method according to claim 1, **characterized in that** the step of applying a second permanent resist layer (11) also comprises applying a permanent resist layer (11) to the side of the printed circuit board (2) opposing the contact side (8) of the printed circuit board (2).

3. The method according to claim 1 or 2, **characterized in that** the structuring of the permanent resist layers (9, 11) comprises exposing the permanent resist layers (9, 11) to a laser.

4. A printed circuit board (2) that can be obtained according to any of claims 1 through 3.

## Revendications

1. - Procédé de connexion et de recâblage d'un composant électronique (1) incorporé dans une carte de circuit imprimé (2), **caractérisé par** les étapes suivantes :
- dépôt d'une première couche de résist permanent (9) sur un côté de connexion (8) de la carte de circuit imprimé (2) ;
- structuration de la première couche de résist permanent (9) afin de réaliser des emplacements dégagés (1) dans la région des contacts (7) du composant électronique (1) ;
- dépôt d'une seconde couche de résist permanent (11) sur la première couche de résist permanent (9) structurée ;
- structuration de la seconde couche de résist permanent (11) afin d'exposer les emplacements dégagés (10) dans la région des contacts (7) et de réaliser des emplacements dégagés (12) correspondant aux pistes conductrices (15) souhaitées ;
- revêtement chimique des emplacements dégagés (10,12) par du cuivre ;
- remplissage galvanique des emplacements dégagés (10,12) par du cuivre ;
- enlèvement du cuivre en excès dans les régions entre les emplacements dégagés (10).

2. - Procédé selon la revendication 1, **caractérisé par le fait que** l'étape de dépôt d'une seconde couche de résist permanent (11) comporte en outre le dépôt d'une couche de résist permanent (11) sur le côté de la carte de circuit imprimé (2) opposé au côté de connexion (8) de la carte de circuit imprimé (2).

3. - Procédé selon l'une des revendications 1 ou 2, **caractérisé par le fait que** la structuration des couches de résist permanent (9,11) comporte l'illumination des couches de résist permanent (9,11) avec un laser.

4. - Carte de circuit imprimé (2) pouvant être obtenue selon l'une des revendications 1 à 3.
